# FASCICULE DE BREVET EUROPEEN

(11) **EP 1 348 322 B1**
(45) Date de publication et mention de la délivrance du brevet: **12.09.2007**
(21) Numéro de dépôt: 01272696.4
(22) Date de dépôt: 14.12.2001
(51) Int. Cl.: H05K 7/14, H01R 12/18

(54) **MODULE D'INTERCONNEXION POUR FOND DE BOîTIER D'APPAREILLAGE ELECTRONIQUE**
VEBINDUNGSANORDNUNG FÜR EINE RÜCKWANDVERDRAHTUNG EINER ELEKTRONISCHEN ANLAGE
INTERCONNECTING MODULE FOR THE BASE OF ELECTRONIC EQUIPMENT CASING

(30) Priorité: 28.12.2000 FR 0017227
(43) Date de publication de la demande: 01.10.2003
(73) Titulaire: Thales, 75008 Paris (FR)
(72) Inventeur: PERRET, François Thales Intellectual Property, F-94117 Arcueil Cedex (FR); NEMOZ, Gérard Thales Intellectual Property, F-94117 Arcueil Cedex (FR); COGNARD, Alain Thales Intellectual Property, (FR); SABOURIN, Joël Thales Intellectual Property, F-94117 Arcueil Cedex (FR)
(74) Mandataire: Brochard, Pascale
(86) Numéro de dépôt international: PCT/FR2001/003987
(87) Numéro de publication internationale: WO 2002/054847

(56) Documents cités:
- US-A- 5 161 986
- US-A- 5 348 482
- US-A- 5 971 773

## Description

La présente invention est relative aux modules d'interconnexion utilisés dans les boîtiers d'appareillage électronique pour les raccordements électriques de leurs cartes de circuits imprimés entre elles et avec l'environnement extérieur. Elle concerne plus particulièrement, les modules d'interconnexion utilisés en fond de panier dans des boîtiers d'appareillage électronique débrochables qui sont montés, de manière amovible, sur des châssis support : berceaux, chaises, armoires ou étagères, etc., et équipés au dos, d'un ou plusieurs demi-connecteurs destinés à coopérer par emboîtement, avec des demi-connecteurs de formes complémentaires montés sur les châssis support, pour assurer les raccordements électriques des appareillages électroniques logés dans les boîtiers avec l'environnement extérieur dans lequel ils sont destinés à fonctionner.

Les boîtiers débrochables pour appareillages électroniques ont l'intérêt de faciliter la maintenance et le dépannage d'un système électronique dont les éléments sont répartis entre plusieurs boîtiers en rendant très simples les opérations de remplacement par échange standard au niveau des boîtiers. On connaît de nombreuses sortes de boîtiers débrochables, la tendance étant à la standardisation, c'est-à-dire à la suppression la plus complète possible des particularisations des boîtiers en fonction des spécificités de raccordement des cartes de circuits imprimés qu'ils sont destinés à recevoir. Cette tendance à la standardisation des boîtiers implique que les modules d'interconnexion utilisés en fond de panier permettent, de façon indifférenciée, à toutes les cartes de circuit imprimé logées dans un boîtier, quelles que soient les spécificités des appareillages électroniques dont elles supportent les composants, d'avoir une possibilité d'accès à tous les points de raccordement du boîtier avec l'environnement extérieur.

Cette contrainte de possibilité d'accès de toutes les cartes de circuits imprimés logées dans un boîtier à tous les points de raccordement du boîtier avec l'environnement extérieur pose un problème d'encombrement des modules d'interconnexion utilisés en fond de panier pour réaliser l'interface entre les cartes de circuits imprimés logées dans le boîtier et les demi-connecteurs montés au dos du boîtier dès que le nombre de points de raccordement dépasse la centaine, cela d'autant plus, si l'on recherche la compacité pour les boîtiers, ce qui est souvent le cas pour du matériel destiné à être embarqué à bord de mobiles.

La présente invention a pour but un module d'interconnexion pour fond de boîtier d'appareillage électronique monté sur des cartes de circuit imprimé qui soit d'un faible encombrement tout autorisant pour le boîtier un grand nombre de points de raccordements électriques avec l'environnement extérieur accessibles de toutes ses cartes de circuit imprimé.

Elle a pour objet un module d'interconnexion pour fond de boîtier d'appareillage électronique qui renferme deux groupes de cartes de circuit imprimé supportant des composants d'appareillages électroniques, chaque groupe étant constitué d'une ou plusieurs cartes de circuit imprimé empilées, et qui possède un dos équipé d'au moins un champ de contacts constituant des points de raccordement électriques accessibles de l'extérieur du boîtier. Ce module d'interconnexion assure le report, au niveau des deux groupes de cartes de circuit imprimé, des points de raccordement du boîtier accessibles de l'extérieur. Il comporte un champ de points de raccordement électrique déporté à l'intérieur du boîtier en vis à vis des deux groupes de cartes de circuit imprimé et des pistes assurant les liaisons électriques entre ce champ déporté de points de raccordement et le champ de contacts équipant le dos du boîtier. Il est remarquable en ce qu'il comporte un support plan en forme de triptyque avec :
- un panneau central, en circuit imprimé, fixé au dos du champ de contacts des points de raccordement du boîtier avec l'environnement extérieur, parallèlement au dos du boîtier, et supportant les pistes de liaison électrique, sur une portion de leurs trajets partant des contacts de ce champ de points de raccordement avec l'environnement extérieur, lesdites pistes se partageant, sur cette portion de leur trajet, en au moins deux groupes allant vers des bords opposés du panneau central dits bords longitudinaux, et
- deux panneaux latéraux en circuit imprimé, repliés et plaqués l'un sur l'autre entre les deux groupes de cartes de circuit imprimé, attachés de part et d'autre du panneau central, chacun par un bord à l'un des bords longitudinaux du panneau central, au moyen d'une pièce de liaison en circuit imprimé souple de dimension suffisante pour permettre leur repliement et leur plaquage l'un sur l'autre, se partageant le champ déporté de points de raccordement et les pistes de liaison qui y mènent depuis le champ de contacts des points de raccordement du boîtier avec l'environnement extérieur,
le champ déporté de points de raccordement étant équipé de contacts traversants, les points de raccordement de la partie du champ déporté portée par un panneau latéral étant décalés latéralement par rapport aux points de raccordement de la partie complémentaire du champ déporté portée par l'autre panneau latéral, les panneaux latéraux supportant les pistes de liaison sur la portion de leurs trajets aboutissant à leur partie de champ déporté de points de raccordement et étant pourvus d'au moins une ouverture laissant la place aux contacts traversant de l'autre panneau latéral, les pistes de liaison aboutissant à la partie de champ déporté de points de raccordement d'un panneau latéral passant, pour rejoindre des contacts du champ de points de raccordement accessibles de l'extérieur du boîtier, par la pièce de liaison attachant l'un des bords du panneau latéral considéré avec l'un des bords longitudinaux du panneau central.

Avantageusement, les panneaux central et latéraux sont des panneaux rigides.

Avantageusement, une cloison métallique de blindage est intercalée entre les deux panneaux latéraux repliés et plaqués l'un sur l'autre.

Avantageusement, les deux panneaux latéraux sont repliés et plaqués l'un sur l'autre parallèlement à un plan perpendiculaire au panneau central.

Avantageusement, les deux panneaux latéraux sont repliés l'un sur l'autre, parallèlement et de part et d'autre du plan perpendiculaire au panneau central, parallèle à ses bords longitudinaux et passant par le milieu du panneau central.

Avantageusement, les extrémités des contacts traversants du champ déporté de points de raccordement forment des broches pour des demi-connecteurs montés dos à dos, de chaque côté du bloc constitué par les deux panneaux latéraux repliés et plaqués l'un sur l'autre, destinés à coopérer par emboîtage avec des demi-connecteurs de formes complémentaires montés sur la carte de circuit imprimé de chacun des deux groupes de cartes de circuit imprimé venant directement en regard des deux panneaux latéraux.

Avantageusement, les panneaux latéraux sont pourvus d'un champ interne de points de raccordement électrique sans liaison avec les contacts du champ de points de raccordement avec l'environnement extérieur au boîtier porté par le panneau central, qui comporte des contacts traversants formant sur les deux faces opposées du bloc constitué par les deux panneaux latéraux repliés et plaqués l'un sur l'autre, des broches de demi-connecteurs destinés à coopérer par emboîtage avec des demi-connecteurs de formes complémentaires montés sur la carte de circuit imprimé de chacun des deux groupes de cartes de circuit imprimé venant directement en regard des deux panneaux latéraux.

Avantageusement, les demi-connecteurs montés de chaque côté du bloc constitué par les deux panneaux latéraux repliés et plaqués l'un sur l'autre comportent indistinctement, des broches constituées de contacts traversant appartenant au champ déporté de points de raccordement et au champ interne de points de raccordement.

Avantageusement, la partie du champ déporté de points de raccordement portée par un panneau latéral est décalée latéralement par rapport à la partie complémentaire du champ déporté de points de raccordement portée par l'autre panneau latéral, chaque panneau latéral comportant une ouverture laissant le passage à la partie de champ déporté de points de raccordement portée par l'autre panneau latéral.

Avantageusement, les demi-connecteurs équipant le bloc constitué des panneaux latéraux repliés et plaqués l'un sur l'autre ont des épaisseurs différentes en fonction du panneau latéral qui les supporte de manière à tous affleurer au même niveau sur chaque face du bloc bien que leurs niveaux de fixation dépendent du panneau latéral qui les supportent.

Avantageusement, les panneaux latéraux ont des contours identiques dissymétriques et sont disposés repliés et plaqués l'un sur l'autre de manière à avoir des contours non coïncidants.

Avantageusement, les demi-connecteurs de formes complémentaires montés sur les cartes de circuit imprimé de chacun des deux groupes de cartes de circuit imprimé venant directement en vis à vis des deux panneaux latéraux présentent des broches constituées de contacts traversants formant à leur autre extrémité, d'autres broches pour des demi-connecteurs montés en face opposée reproduisant les demi-connecteurs des deux panneaux latéraux et rendant accessibles les champs de points de raccordement des panneaux latéraux à la carte suivante de circuit imprimé appartenant au même groupe.

Avantageusement, les cartes de circuit imprimé d'un groupe comportent des contacts traversants en alignement avec ceux des champs de points de raccordement porté par les panneaux latéraux, formant, sur une face de la carte, des broches de demi-connecteurs emboîtables de formes complémentaires aux demi-connecteurs emboîtables des panneaux latéraux et sur l'autre face des demi-connecteurs emboîtables de mêmes formes que ceux des panneaux latéraux permettant, en s'emboîtant, de réaliser avec les cartes de circuit imprimé d'un groupe une pile de cartes de circuit imprimé ayant accès à l'ensemble des point de raccordement des champs de points de raccordement des panneaux latéraux.

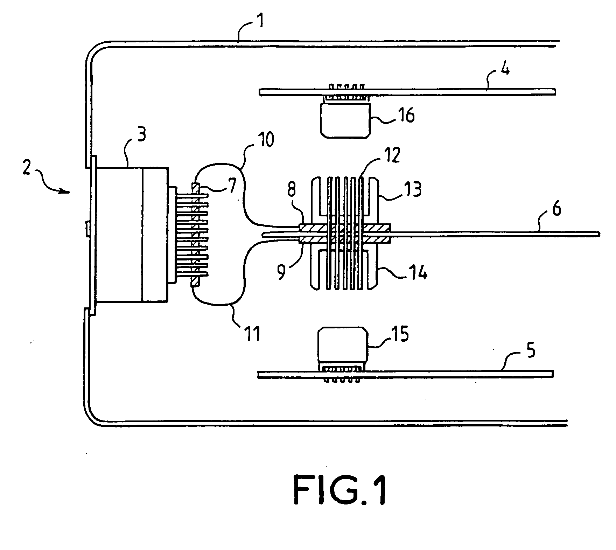

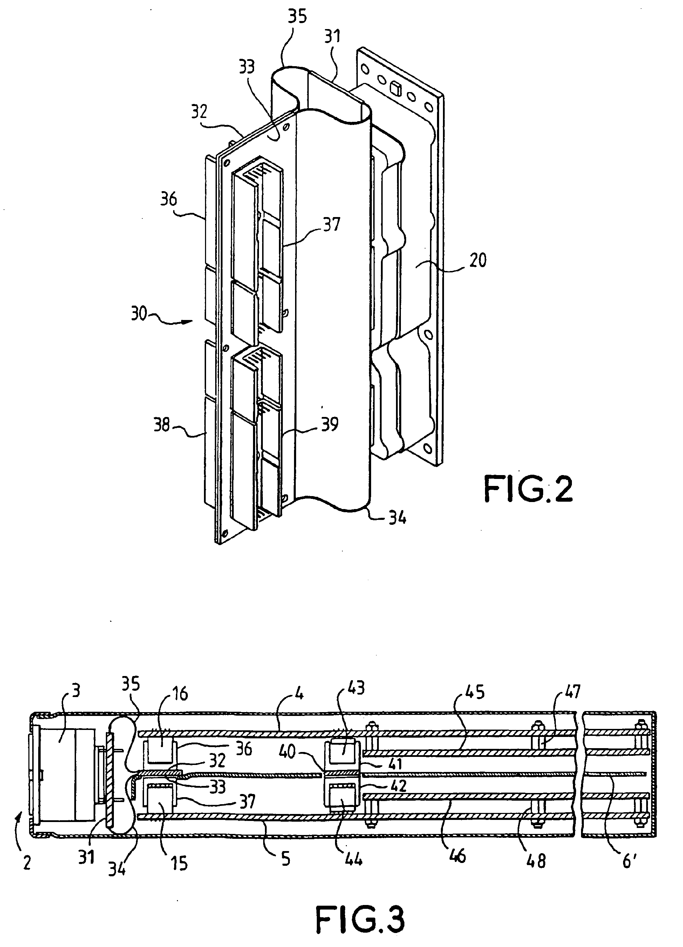

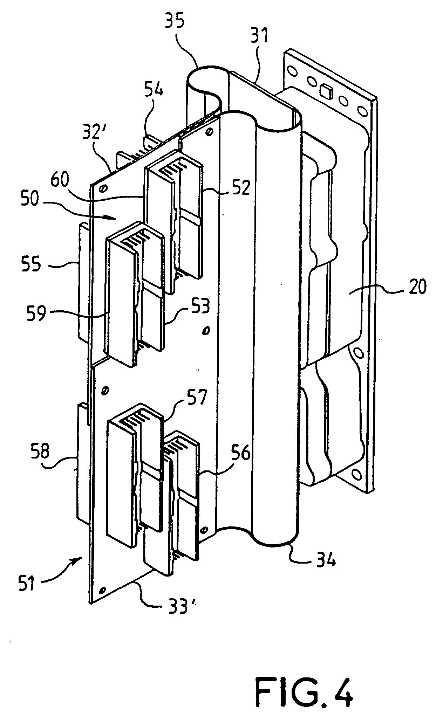

D'autres caractéristiques et avantages de l'invention ressortiront de la description ci-après d'un mode de réalisation donné à titre d'exemple. Cette description sera faite en regard du dessin dans lequel :
- une figure 1 est un schéma illustrant l'architecture d'un module d'interconnexion selon l'invention et une de ses dispositions possibles au sein d'un boîtier,
- une figure 2 est une vue en perspective d'un module d'interconnexion selon l'invention monté au dos d'un demi-connecteur destiné à équiper un dos de boîtier pour assurer les connexions avec l'environnement extérieur,
- une figure 3 est une vue en coupe d'un boîtier équipé du module d'interconnexion illustré à la figure 2, et
- une figure 4 est une vue en perspective, d'un autre module d'interconnexion selon l'invention.

La figure 1 montre, en coupe, la partie arrière d'un boîtier d'appareillage électronique ayant la forme parallélépipédique usuelle d'un gros livre, avec une carrosserie 1 présentant une ouverture 2 au dos du boîtier laissant apparaître un demi-connecteur multibroche 3 destiné à s'emboîter sur un demi-connecteur de forme complémentaire équipant un berceau destiné à recevoir le boîtier.

Le boîtier renferme un ou plusieurs appareillages électroniques dont les composants sont montés sur deux cartes 4 et 5 de circuit imprimé disposées parallèlement aux plus grandes faces du boîtier et séparées l'une de l'autre, par une plaque métallique de blindage 6.

Le ou les appareillages électroniques dont les composants sont montés sur les plaques de circuit imprimé 4, 5 sont supposés échanger des signaux électriques avec d'autres appareillages électroniques logés dans d'autres boîtiers et ont besoin de ce fait de leur être raccordés en passant par l'environnement extérieur au boîtier.

Le demi-connecteur multibroche 3 fixé au dos du boîtier et accessible de l'extérieur assure cette fonction de raccordement électrique avec l'environnement extérieur au boîtier, à la transition entre le boîtier et son berceau mais il reste à réaliser, à l'intérieur du boîtier, les raccordements entre les queues arrières des broches du demi-connecteur 3 et les pistes des cartes de circuit imprimé 4, 5 supportant les composants du ou des appareillages logés dans le boîtier.

Ces raccordements sont, en général, effectués, à l'intérieur d'un boîtier, à l'aide d'une carte de fond de panier constituée d'un unique circuit imprimé rigide. Ce dernier est alors fixé directement aux queues arrières des broches du demi-connecteur 3 tournées vers l'intérieur du boîtier, parallèlement à la paroi de fond du boîtier. Il est équipé, face aux tranches des cartes de circuit imprimé supportant les composants des appareillages logés dans le boîtier, de rangées de demi-connecteurs emboîtables prévus pour s'accoupler avec des demi-connecteurs de formes complémentaires fixés aux tranches de ces cartes et pourvu d'un réseau de pistes assurant les liaisons électriques nécessaires entre les broches des différents demi-connecteurs.

US5, 348, 482 décrit un tel raccordement réalisé non pas à l'aide d'un circuit imprimé rigide mais avec un circuit imprimé souple. Les extrémités de ce circuit imprimé souple, comportant les demi-connecteurs emboîtables pour le raccordement avec l'environnement extérieur au boîtier, sont repliées et plaquées sur la partie centrale de ce circuit imprimé souple portant les connecteurs de raccordement aux tranches des cartes de circuit imprimé.

Dès que le nombre de points de raccordement à assurer devient important, cette manière de réaliser les raccordements au sein d'un boîtier, à l'interface entre les cartes de circuit imprimé des appareillages électroniques et le ou les demi-connecteurs emboîtables fixés au dos du boîtier donnant accès à l'environnement extérieur, présente l'inconvénient de nécessiter un espace important au sein du boîtier pour loger le réseau de connecteurs assurant les liaisons électriques au niveau des tranches des cartes de circuit imprimé. Ainsi, il n'est pas rare que l'on ait à prévoir sur un boîtier d'appareillage électronique, plusieurs centaines de points de raccordement avec l'environnement extérieur, par exemple de quatre à six cents. Dans ces conditions, le boîtier doit être prévu beaucoup plus volumineux que ne le voudrait le simple logement des cartes de circuit imprimé supportant les composants des appareillages électroniques placés dans le boîtier. Il s'ensuit un manque de compacité des boîtiers qui est souvent pénalisant lorsqu'il s'agit d'équipements destinés à être embarqués à bord de mobiles où la place est souvent comptée.

Une manière connue de restreindre l'encombrement de la carte de fond de panier d'un boîtier d'appareillages électroniques consiste à réduire le plus possible le nombre des connexions internes qu'elle réalise en n'assurant que les connexions indispensables, ce qui revient à particulariser les boîtiers en fonction des spécificités de raccordement des types de cartes de circuit imprimé qu'ils sont effectivement destinés à contenir. Cela va à l'encontre de la tendance actuelle à la standardisation des boîtiers qui veut que l'on évite le plus possible de particulariser les boîtiers en fonction des types de cartes de circuit imprimé qu'ils sont destinés à contenir, deux types de cartes n'ayant que rarement, les mêmes exigences de raccordement.

On propose ici, un module d'interconnexion jouant le rôle d'une carte de fond de panier, permettant, à toutes les cartes de circuit imprimé d'un boîtier, un accès à l'ensemble des points de raccordement du boîtier avec l'environnement extérieur tout en étant d'une grande compacité. Dans ce module d'interconnexion, le faible encombrement est obtenu en déportant, les connexions avec les cartes de circuit imprimé 4, 5 supportant les composants des appareillages électroniques logés dans le boîtier de la tranche de ces dernières vers leurs flancs.

Comme montré sur la figure 1, le module d'interconnexion se présente sous la forme d'un triptyque avec un panneau central 7 fixé au dos des broches du demi-connecteur 3 monté sur la paroi arrière du boîtier et deux panneaux latéraux 8, 9 rattachés par un côté aux bords latéraux du panneau central 7, au moyen de deux circuits imprimés souples 10, 11, repliés, plaqués dos à dos et fixés à la cloison de blindage 6.

Plus précisément, le panneau central 7 est constitué d'un circuit imprimé rigide fixé, à l'intérieur du boîtier, aux queues arrières des broches du demi-connecteur 3 et supportant des pistes de liaison électrique partant des broches du demi-connecteur 3 et se partageant en deux groupes en direction de ses deux bords opposés attachés aux panneaux latéraux 8, 9 par les circuits imprimés souples 10, 11.

Les panneaux latéraux 8, 9 sont constitués de deux circuits imprimés rigides repliés et plaqués dos à dos, perpendiculairement au panneau central 7, de part et d'autre de la cloison de blindage 6, les circuits imprimés souples 10, 11 ayant des largeurs suffisantes pour permettre cette disposition. Ils se partagent d'une part, un champ déporté de points de raccordement qui reproduit, en vis à vis des flancs des cartes de circuit imprimé 4, 5 supportant les composants des appareillages électroniques logés dans le boîtier, le champ de points de raccordement avec l'environnement extérieur correspondant aux broches du demi-connecteur 3 fixé au dos du boîtier, et d'autre part, les prolongements des pistes de liaison électrique provenant du panneau central par l'intermédiaire des circuits imprimés souples de rattachement 10, 11.

Les panneaux latéraux 8, 9, de même que la cloison de blindage 6 au niveau des panneaux latéraux 8, 9 sont percés de réseaux de trous qui se correspondent et permettent les passages de contacts traversants 12 matérialisant le champ déporté de points de raccordement. Sur trois trous alignés traversés par un même contact traversant 12, seul l'un d'entre eux pratiqué dans l'un des panneaux latéraux sert de destination à une piste de liaison électrique avec une broche de contact du demi-connecteur 3 fixé au dos du boîtier, les deux autres pratiqués l'un dans la plaque de blindage 6 et l'autre dans l'autre panneau latéral étant de simples trous, soit suffisamment larges pour éviter tout contact susceptible d'assurer une transmission électrique avec le contact traversant 12, soit à paroi isolante.

Les deux extrémités des contacts traversants 12 constituent des broches pour des demi-connecteurs emboîtables dont les socles 13, 14 sont fixés sur les flancs opposés du bloc constitué des panneaux latéraux 8, 9 repliés et plaqués dos à dos, et sont dirigés en direction de demi-connecteurs 15, 16, de formes complémentaires, fixés sur les faces en regard des cartes de circuit imprimé 4, 5 portant les composants des appareillages électroniques logés dans le boîtier.

Les pistes de liaison électrique, qui aboutissent sur les panneaux latéraux aux réseaux de trous équipés de contacts traversants 12, sont réparties, de manière à peu près équitable, sur les deux panneaux latéraux 8, 9 et se partagent en deux groupes aux cheminements différents passant par les deux bords longitudinaux du panneau central 7. Cette répartition facilite le routage des différentes pistes de liaison électrique puisqu'elle double les possibilités de tracé, ce qui permet de diminuer le nombre de couches et donc la complexité des circuits imprimés utilisés pour les panneaux central 7 et latéraux 8, 9.

La réalisation du module d'interconnexion sous la forme de trois panneaux de circuit imprimé rigides rattachés par des circuits imprimés souples ne sera pas détaillée car elle fait partie des connaissances de l'homme du métier. Dans le cadre de circuits imprimés multicouches, la structure en triptyque peut être obtenue au niveau de chaque couche, avant l'empilage et la solidarisation des couches par collage.

Le fait d'utiliser un champ déporté de points de raccordement en liaison électrique avec le champ de points de raccordement du boîtier avec l'environnement extérieur, réorienté de la tranche vers les flancs des cartes de circuit imprimé supportant les composants des appareillages électroniques logés dans le boîtier grâce à un module d'interconnexion en circuits imprimés repliables permet de prendre l'espace nécessaire aux connecteurs emboîtables de liaison avec ces cartes de circuits imprimés non pas sur l'espacement entre cartes mais sur la surface des cartes, ce qui permet de préserver la compacité du boîtier. En effet, l'espacement entre les cartes de circuit imprimé supportant les composants des appareillages électroniques logés dans un boîtier est toujours faible du fait du peu de hauteur des composants. La disposition des connecteurs sur les tranches des cartes impose nécessairement une augmentation de cet espacement dès que le nombre de points de raccordement à assurer devient important, augmentation qui se traduit par une mauvaise utilisation du volume entre cartes. Par contre, la disposition des demi-connecteurs à la surface des cartes ne se traduit que par une faible augmentation de la profondeur du boîtier.

Le champ déporté de points de raccordement peut comporter plus d'éléments que le champ de points de raccordement avec l'environnement extérieur correspondant aux broches du demi-connecteur 3 monté au dos du boîtier, les éléments surnuméraires étant aussi équipés de contacts traversants et constituant un champ interne de points de raccordement entre les deux cartes de circuit imprimé 4, 5 sans liaison électrique avec les broches du demi-connecteur 3 monté au dos du boîtier.

Les cartes de circuit imprimé 4, 5 peuvent ne pas être isolées, mais faire partie de deux empilements de cartes. Elles sont alors également équipées de contacts traversants, les extrémités de ces contacts traversants tournées en regard des panneaux latéraux 8, 9 constituant des broches pour les demi-connecteurs 15, 16 destinés à s'emboîter sur les demi-connecteurs 13, 14 des panneaux latéraux 8, 9, et les extrémités opposées de ces contacts traversants tournant le dos aux panneaux latéraux 8, 9 constituant des broches pour des demi-connecteurs non représentés reproduisant les demi-connecteurs 13, 14 des panneau latéraux 8, 9 pour la carte suivante de l'empilement.

La figure 2 montre, en perspective, un exemple de réalisation du module d'interconnexion schématisé à la figure 1, monté sur les queues arrières des broches d'un demi-connecteur emboîtable destiné à être fixé au dos d'un boîtier pour assurer des raccordements avec l'environnement extérieur du boîtier. Le corps 20 du connecteur emboîtable destiné à être fixée sur le dos du boîtier est visible de l'arrière. Les queues arrières des broches de ce connecteur emboîtable fixé au dos du boîtier sont masquées par le module d'interconnexion 30 dont on distingue la structure en forme de triptyque, avec son panneau central rigide 31 venant au-dessus du corps 20 du connecteur, ses deux panneaux latéraux rigides 32, 33 repliés et plaqués l'un sur l'autre dans un plan perpendiculaire au panneau central 31 et les circuits imprimés souples 34, 35 rattachant chacun des panneaux latéraux 32, 33 à un bord longitudinal distinct du panneau central 31.

Le panneau central 31, de dimension rectangulaire allongée, est disposé parallèlement au dos du boîtier, fixé sur les queues arrières des broches du demi-connecteur dont on aperçoit le corps 20.

Les deux panneaux latéraux 32, 33 qui ont ici un même contour rectangulaire allongé, sont repliés et plaqué l'un contre l'autre de part et d'autre d'un plan perpendiculaire au dos du boîtier passant par la médiane longitudinale du panneau central 31 qui est également celle du demi-connecteur fixé au dos du boîtier, les circuits imprimés souples 34, 35 les rattachant par un bord longitudinal aux bords longitudinaux du panneau central 31 ayant une largeur suffisante pour permettre cette disposition.

Chaque panneau latéral 32 ou 33 reproduit, en une localisation déportée en vis à vis des faces des cartes de circuit imprimé logées dans le boîtier, le champ de points de raccordement avec l'environnement extérieur du boîtier matérialisé au niveau du panneau central 31 par les queues arrières des broches du demi-connecteur fixé au dos du boîtier. Ce champ déporté est matérialisé au niveau des deux panneaux latéraux 32, 33, par deux réseaux de trous, un sur chaque panneau latéral 32 ou 33, qui se superposent lors du repliement et du plaquage l'un sur l'autre des deux panneaux latéraux 32, 33 et au travers desquels sont enfilés des contacts traversants servant, sur chaque face du bloc constitué par les deux panneaux latéraux 32, 33 repliés et plaqués l'un sur l'autre, de broches à des demi-connecteurs emboîtables dont on distingue les corps à détrompage 36, 37, 38, 39 et qui sont destinés, comme on peut mieux le voir sur la figure 3, à coopérer avec des demi-connecteurs 15, 16 de formes complémentaires équipant les deux cartes de circuit imprimé 40, 41 se logeant dans le boîtier.

Comme indiqué précédemment, le réseau de paires de trous alignés matérialisant le champ déporté de points de raccordement au sein du bloc formé par les deux panneaux latéraux 32, 33 repliés et plaqués l'un sur l'autre, est relié par des pistes de liaison électrique au champ de points de raccordement du boîtier avec l'environnement extérieur matérialisé sur le panneau central 31 par les queues arrières des broches de connexion du demi-connecteur fixé au dos du boîtier. Ces pistes non visibles sur la figure 2, se partagent à peu près équitablement entre les deux panneaux latéraux 32 et 33, et les circuits imprimés souples de rattachement 34, 35 des panneaux latéraux 32, 33 au panneau central 31. Elles aboutissent, côté panneaux latéraux 32, 33 à l'un des trous d'une paire occupée par un contact traversant, celui pratiqué au travers du panneau latéral 32 ou 33 supportant la piste tandis que l'autre trou appartenant à l'autre panneau latéral reste sans piste affectée.

La figure 3 est une vue en coupe d'un boîtier, selon son épaisseur. Ce boîtier reprend les principales caractéristiques de l'architecture décrite relativement à la figure 1. Il est de forme parallélépipédique avec une paroi 1 de coupe rectangulaire. Il renferme un ou plusieurs appareillages électroniques dont les composants sont montés sur deux cartes de circuit imprimé 4, 5 disposées à plat, de part et d'autre d'une cloison métallique de blindage 6' placée au centre du boîtier. Il est équipé d'un demi-connecteur emboîtable multibroche 3 monté dans une ouverture 2 de sa paroi dorsale assurant les raccordements électriques des appareillages logés dans le boîtier avec l'environnement extérieur au boîtier et d'un module d'interconnexion assurant l'interface entre ce demi-connecteur 3 et les cartes de circuit imprimé 4, 5.

Le module d'interconnexion est celui représenté à la figure 2, avec sa conformation en triptyque. Son panneau central rigide 31 est fixé aux queues arrières des broches du demi-connecteur 3, parallèlement à la paroi dorsale du boîtier. Ses panneaux latéraux 32 et 33, rattachés aux bords longitudinaux du panneau central 31 par deux circuits imprimés souples 34, 35, sont repliés, plaqués l'un sur l'autre, fixés au travers d'une ouverture de la cloison de blindage 6'. Le bloc qu'ils constituent supporte des demi-connecteurs emboîtables 36, 37 destinés à coopérer avec des demi-connecteurs 16, 15 de formes complémentaires, montés sur les faces en regard des cartes de circuit imprimé 4, 5 supportant les composants des appareillages électroniques logés dans le boîtier.

La principale différence par rapport au module d'interconnexion schématisé dans la figure 1 se situe au niveau du bloc constitué par les deux panneaux latéraux 32, 33 repliés et plaqués directement l'un sur l'autre et non pas de part et d'autre de la plaque de blindage. Cette différence dans le montage des panneaux latéraux 32, 33 facilite la réalisation du boîtier puisque sa plaque de blindage n'a plus à présenter un réseau de trous individuels pour les contacts traversants mais seulement une ouverture globale. Elle facilite surtout le montage des contacts traversants au travers des panneaux latéraux 32, 33 puisque le bloc qu'ils constituent n'inclut plus la plaque de blindage.

Une autre différence consiste dans la présence, au travers d'une ouverture de la plaque de blindage 6', d'une plaquette isolante 40 supportant un champ de contacts traversants servant de broches à des demi-connecteurs emboîtables 41, 42 montés sur les faces opposées de la plaquette 40 et coopérant avec des demi-connecteurs 43, 44 de formes complémentaires fixés aux faces en regard des cartes de circuit imprimé 4, 5 supportant les composants des appareillages électroniques logés dans le boîtier. Ce champ de contacts traversants constitue un champ interne de points de raccordement assurant des interconnexions électriques entre les cartes de circuit imprimé 4, 5, sans relation avec le champ de point de raccordement avec l'environnement extérieur au boîtier matérialisé par les broches du demi-connecteur 3 fixé au dos du boîtier.

Dans le cas où les composants montés sur les cartes de circuit imprimé 4, 5 ont des hauteurs moindres que les connecteurs 16-36, 15-37, 41-43, 42-44, il est possible d'occuper l'espace imposé par la hauteur des connecteurs entre les cartes de circuit imprimé 4, 5 et la plaque de blindage 6' par une carte auxiliaire de circuit imprimé 45, 46 placé en mezzanine au moyen d'entretoises 47, 48, ces cartes auxiliaires 45, 46 pouvant être raccordées à leur carte porteuse par des connexions par fils ou par circuits imprimés souples.

La figure 4 montre, en perspective, un autre exemple de réalisation du module d'interconnexion schématisé à la figure 1. Cet exemple de réalisation est proche de celui précédemment décrit relativement à la figure 2. Il s'en différencie cependant, par la forme du contour des panneaux latéraux 32' et 33' qui n'est plus simplement rectangulaire, mais qui présente une large encoche 50, 51. Les deux panneaux latéraux 32' et 33' sont repliés et plaqués l'un sur l'autre de manière que leurs encoches 50, 51 ne se superposent pas mais laissent apparaître la face sous-jacente de l'autre panneau latéral.

Comme précédemment, les deux panneaux latéraux 32' et 33' reproduisent, en une localisation déportée en vis à vis des faces des cartes de circuit imprimé logées dans le boîtier, le champ de points de raccordement avec l'environnement extérieur du boîtier matérialisé au niveau du panneau central 31 par les queues arrières des broches du demi-connecteur qui est fixé au dos du boîtier et dont le corps apparaît en 20 sur la figure 4. Ce champ déporté de points de raccordement, qui est en relation avec le champ de points de raccordement avec l'environnement extérieur porté par le panneau central 31, par l'intermédiaire de pistes de liaison électrique se partageant entre les deux panneaux latéraux 32', 33' et les circuits imprimés souples 34, 35 les rattachant aux bords longitudinaux du panneau central 31, est toujours matérialisé par des contacts traversants dont les extrémités servent de broches à des demi-connecteurs emboîtables 52 à 58 montés sur les deux faces des panneaux latéraux 32' 33'. Par contre, contrairement au mode de réalisation de la figure 2, la partie de champ déporté de points de raccordement portée par l'un 32' respectivement 33' des panneaux latéraux et la partie complémentaire de champ déporté de points de raccordement portée par l'autre panneau latéral 33' respectivement 32' ne sont plus enchevêtrées mais séparées géographiquement. La partie de champ déporté de points de raccordement portée par un panneau latéral 32' ou 33' occupe, dans le bloc formé par les panneaux latéraux 32' et 33' repliés et plaqués l'un sur l'autre, l'emplacement libéré par l'encoche de l'autre et réciproquement. C'est ainsi que sur la figure 4, la partie de champ déporté de points de raccordement portée par le panneau latéral 32' est matérialisé par les contacts traversants constituant les broches des demi-connecteurs 52 à 55 placés au niveau de l'encoche 50 du panneau latéral 33' tandis que la partie complémentaire du champ déporté de points de raccordement portée par le panneau latéral 33' est matérialisée par les contacts traversants constituant les broches des demi-connecteurs 56 à 58 placés au niveau de l'encoche 51 du panneau latéral 32'.

Cette disposition permet le montage des demi-connecteurs 52 à 58 du champ déporté de points de raccordement, individuellement sur chaque panneau latéraux 32' et 33' et non pas sur le bloc formé par les deux panneaux latéraux repliés et plaqués l'un sur l'autre. Cela a l'avantage d'éliminer les problèmes posés par la maîtrise de l'épaisseur du bloc formé par les deux panneaux latéraux repliés et plaqués l'un sur l'autre lors du montage des demi-connecteurs par des machines automatiques réalisant la pose des corps à détrompage des demi-connecteurs et l'insertion à force des contacts traversants constituant leurs broches. En contrepartie, il est nécessaire de prévoir des cales d'épaisseur 59, 60 pour uniformiser la hauteur de tous les demi-connecteurs accessibles d'une même face du bloc constitué par les deux panneaux latéraux 32', 33' repliés et plaqués l'un sur l'autre

On a supposé, tout au long de la description précédente, que l'ensemble du champ de points de raccordement avec l'environnement extérieur au boîtier était relayé au niveau du champ déporté de points de raccordement porté par les panneaux latéraux du module d'interconnexion, il va s'en dire qu'il s'agit des points de raccordement pouvant intéresser l'un des appareillages dont les composants sont portés par les cartes de circuit imprimé logées dans le boîtier, un certain nombre de points de raccordement avec l'environnement extérieur au boîtier n'intéressant pas ces cartes n'étant pas relayés au niveau du champ déporté de contact mais câblés directement vers des circuits autres, souvent accessoires, montés en dehors de ces cartes de circuit imprimé.

## Revendications

1. Module d'interconnexion pour fond de boîtier d'appareillage électronique qui renferme deux groupes de cartes (4, 5) de circuit imprimé supportant des composants d'appareillages électroniques, chaque groupe étant constitué d'une ou plusieurs cartes de circuit imprimé empilées, et qui possède un dos équipé d'au moins un champ de contacts (3) constituant des points de raccordement électriques accessibles de l'extérieur du boîtier, ledit module d'interconnexion assurant le report, au niveau des deux groupes de cartes (4, 5) de circuit imprimé, des points de raccordement (3) du boîtier accessibles de l'extérieur, ledit module d'interconnexion comportant un champ de points (36 à 39, 52 à 58) de raccordement électrique déporté à l'intérieur du boîtier en vis à vis des deux groupes de cartes (4,5) de circuit imprimé et des pistes assurant les liaisons électriques entre ce champ déporté de points (36 à 39, 52 à 58) de raccordement et le champ de contacts (3) équipant le dos du boîtier, et étant **caractérisé en ce qu'**il comporte un support plan en forme de triptyque avec :
• un panneau central (7, 31) en circuit imprimé, fixé au dos du champ de contacts (3) des points de raccordement du boîtier avec l'environnement extérieur, parallèlement au dos du boîtier, et supportant les pistes de liaison électrique, sur une portion de leurs trajets partant des contacts (3) de ce champ de points de raccordement avec l'environnement extérieur, lesdites pistes se partageant, sur cette portion de leur trajet, en au moins deux groupes allant vers des bords opposés du panneau central, dits bords longitudinaux, et
• deux panneaux latéraux (8, 9, 32, 33, 32', 33') en circuit imprimé, repliés et plaqués l'un sur l'autre entre les deux groupes de cartes (4, 5) de circuit imprimé, attachés de part et d'autre du panneau central (7, 31), chacun par un bord à l'un des bords longitudinaux du panneau central (7, 31), au moyen d'une pièce de liaison (10, 11, 34, 35) en circuit imprimé souple de dimension suffisante pour permettre leur repliement et leur plaquage l'un sur l'autre, se partageant le champ déporté de points (36 à 39, 52 à 58) de raccordement et les pistes de liaison qui y mènent depuis le champ de contacts (3) des points de raccordement du boîtier avec l'environnement extérieur,
le champ déporté de points (36 à 39, 52 à 58) de raccordement étant équipé de contacts traversants (12), les points de raccordement de la partie du champ déporté portée par un panneau latéral étant décalés latéralement par rapport aux points de raccordement de la partie complémentaire du champ déporté portée par l'autre panneau latéral, les panneaux latéraux (8, 9, 32, 33) supportant les pistes de liaison sur la portion de leurs trajets aboutissant à leur partie de champ déporté de points de raccordement et étant pourvus d'au moins une ouverture laissant la place aux contacts traversants (12) de l'autre panneau latéral, les pistes de liaison aboutissant à la partie de champ déporté de points (36 à 39, 52 à 58) de raccordement d'un panneau latéral passant, pour rejoindre des contacts (3) du champ de points de raccordement accessibles de l'extérieur du boîtier, par la pièce de liaison (10, 11, 33, 34) attachant l'un des bords du panneau latéral considéré (8, 9, 32, 33, 32', 33') avec l'un des bords longitudinaux du panneau central (7, 31).

2. Module selon la revendication 1, **caractérisé en ce que** les panneaux central (7, 31) et latéraux (8, 9, 32, 33, 32', 33') sont des panneaux rigides.

3. Module selon la revendication 1, adapté à un boîtier comportant une cloison métallique de blindage (6, 6') séparant les deux groupes de cartes (4, 5) de circuit imprimé **caractérisé en ce que** ladite cloison de blindage (6, 6') est intercalée entre les deux panneaux latéraux (8, 9, 32, 33) repliés et plaqués l'un sur l'autre.

4. Module selon la revendication 1, **caractérisé en ce que** les deux panneaux latéraux (8, 9, 32, 33, 32', 33') sont repliés et plaqués l'un sur l'autre parallèlement à un plan perpendiculaire au panneau central (7, 31).

5. Module selon la revendication 1, **caractérisé en ce que** les deux panneaux latéraux (8, 9, 32, 33, 32', 33') sont repliés et plaqués l'un sur l'autre, parallèlement et de part et d'autre d'un plan perpendiculaire au panneau central (7, 31), parallèle aux bords longitudinaux de ce dernier et passant par son milieu.

6. Module selon la revendication 1, **caractérisé en ce que** les extrémités des contacts traversants (12) du champ déporté de points de raccordement forment des broches pour des demi-connecteurs (36 à 39, 52 à 58) montés dos à dos, de chaque côté du bloc constitué par les deux panneaux latéraux (8, 9, 32, 33, 32', 33') repliés et plaqués l'un sur l'autre, destinés à coopérer par emboîtage avec des demi-connecteurs (15, 16) de formes complémentaires montés sur la carte (4, 5) de circuit imprimé de chacun des deux groupes de cartes de circuit imprimé venant directement en regard des deux panneaux latéraux (8, 9, 32, 33, 32', 33').

7. Module selon la revendication 1, **caractérisé en ce que** les panneaux latéraux 8,9, 32, 33, 38',33' sont pourvus d'un champ interne de points de raccordement électrique assurant les interconnexions électriques entre les deux groupes de cartes (4,5) de circuit imprimé sans liaison avec les contacts (3) du champ de points de raccordement avec l'environnement extérieur au boîtier porté par le panneau central (7, 31), ledit champ interne de points de raccordement comportant des contacts traversants formant sur les deux faces opposées du bloc constitué par les deux panneaux latéraux (8, 9, 32, 33, 32', 33') repliés et plaqués l'un sur l'autre, des broches de demi-connecteurs (41, 42) destinés à coopérer par emboîtage avec des demi-connecteurs (43, 44) de formes complémentaires montés sur la carte (4, 5) de circuit imprimé de chacun des deux groupes de cartes de circuit imprimé venant directement en regard des deux panneaux latéraux (32, 33).

8. Module selon la revendication 7, **caractérisé en ce que** les demi-connecteurs montés de chaque côté du bloc constitué par les deux panneaux latéraux (8, 9, 32, 33, 32', 33') repliés et plaqués l'un sur l'autre comportent indistinctement, des broches constituées de contacts traversant (12) appartenant au champ déporté de points (36 à 39, 52 à 58) de raccordement et au champ interne de points de raccordement.

9. Module selon la revendication 1, **caractérisé en ce que** la partie (52 à 55) du champ déporté de points de raccordement portée par un panneau latéral (32') est décalée latéralement par rapport à la partie complémentaire (56 à 58) du champ déporté de points de raccordement portée par l'autre panneau latéral (33'), chaque panneau latéral (32' ou 33') comportant une ouverture (50, 50') laissant le passage à la partie (52 à 55 ou 56 à 58) de champ déporté de points de raccordement portée par l'autre panneau latéral (33' ou 32').

10. Module selon la revendication 9, **caractérisé en ce que** les extrémités des contacts traversants (12) du champ déporté de points de raccordement forment des demi-connecteurs (52 à 58) équipant le bloc constitué des panneaux latéraux (32', 33') repliés et plaqués l'un sur l'autre ont des épaisseurs différentes en fonction du panneau latéral (32' ou 33') qui les supporte de manière à tous affleurer au même niveau sur chaque face du bloc bien que leurs niveaux de fixation dépendent du panneau latéral (32', 33') qui les supportent.

11. Module selon la revendication 10, **caractérisé en ce que** les différences d'épaisseur imposées aux demi-connecteurs (52 à 58) équipant le bloc constitué des panneaux latéraux (32', 33') repliés et plaqués l'un contre l'autre, pour qu'ils affleurent au même niveau sont obtenues au moyen de cales d'épaisseur (59, 60).

12. Module selon la revendication 9, **caractérisé en ce que** les panneaux latéraux (32', 33') ont des contours identiques dissymétriques et sont disposés repliés et plaqués l'un sur l'autre de manière à avoir des contours non coïncidents.

13. Module selon la revendication 1, **caractérisé en ce que** les extrémités des contacts traversants (12) du champ déporté de points de raccordement forment des demi-connecteurs (36 à 39 et 52 à 58) équipant le bloc constitué des panneaux latéraux (8, 9, 32, 32, 32', 33') repliés et plaqués l'un sur l'autre coopérent avec des demi-connecteurs de formes complémentaires montés sur les cartes (4, 5) de circuit imprimé de chacun des deux groupes de cartes de circuit imprimé venant directement en vis à vis des deux panneaux latéraux (8, 9, 32, 33, 32', 33') dont les broches sont constituées de contacts traversants formant à leur autre extrémité, d'autres broches pour des demi-connecteurs montés en face opposée reproduisant les demi-connecteurs des deux panneaux latéraux (8, 9, 32, 33, 32', 33') et rendant accessibles les champs de points de raccordement des panneaux latéraux (8, 9, 32, 33, 32', 33') à la carte suivante de circuit imprimé appartenant au même groupe.

14. Module selon la revendication 13, **caractérisé en ce que** les cartes (4, 5) de circuit imprimé d'un groupe comportent des contacts traversants en alignement avec ceux des demi-connecteurs (36 à 39, 52 à 58) portés par les panneaux latéraux (8, 9, 32, 33, 32', 33'), formant, sur une face de la carte (4, 5), des broches de demi-connecteurs emboîtables de formes complémentaires aux demi-connecteurs emboîtables des panneaux latéraux (8, 9, 32, 33, 32', 33') et sur l'autre face des demi-connecteurs emboîtables de mêmes formes que ceux des panneaux latéraux permettant, en s'emboîtant, de réaliser avec les cartes de circuit imprimé d'un groupe une pile de cartes de circuit imprimé ayant accès à l'ensemble des point de raccordement des champs de points de raccordement des panneaux latéraux.

## Claims

1. Interconnection module for an electronic gear unit backplane holding two groups of printed circuit cards (4, 5) supporting electronic gear components, each group comprising one or more stacked printed circuit cards, and which has a back equipped with at least one field of contacts (3) forming electrical connection points accessible from outside the unit, said interconnection module providing the offset, at the level of the two groups of printed circuit cards (4, 5), for the connection points (3) of the unit accessible externally, said interconnection module comprising an offset field of electrical connection points (36 to 39, 52 to 58) inside the unit facing the two groups of printed circuit cards (4, 5) and tracks providing electrical links between this offset field of connection points (36 to 39, 52 to 58) and the field of contacts (3) provided on the back of the unit, and being **characterized in that** it comprises a triptychform flat support, with:
• a central printed circuit panel (7, 31), fixed to the back of the field of contacts (3) of the connection points of the unit with the external environment, parallel to the back of the unit, and supporting the electrical link tracks, over a portion of their paths starting from the contacts (3) of this field of connection points with the external environment, said tracks being split, over this portion of their path, into at least two groups going to the opposite edges of the central panel, called longitudinal edges, and
• two printed circuit side panels (8, 9, 32, 33, 32', 33'), folded and placed flat against one another between the two groups of printed circuit cards (4, 5), attached either side of the central panel (7, 31), each by an edge to one of the longitudinal edges of the central panel (7, 31), by means of a flexible printed circuit link part (10, 11, 34, 35) of sufficient size to allow them to be folded and placed flat against one another, sharing the offset field of connection points (36 to 39, 52 to 58) and the link tracks that lead to it from the field of contacts (3) of the connection points of the unit with the external environment,
the offset field of connection points (36 to 39, 52 to 58) being equipped with through contacts (12), the connection points of the part of the offset field borne by a side panel being laterally offset relative to the connection points of the complementary part of the offset field borne by the other side panel, the side panels (8, 9, 32, 33) supporting the link tracks over the portion of their paths culminating at their part of the offset field of connection points and being provided with at least one opening allowing space for the through contacts (12) of the other side panel, the link tracks culminating at the part of the offset field of connection points (36 to 39, 52 to 58) of a transit side panel, to meet the contacts (3) of the field of connection points accessible from outside the unit, via the link part (10, 11, 33, 34) attaching one of the edges of the side panel concerned (8, 9, 32, 33, 32', 33') with one of the longitudinal edges of the central panel (7, 31).

2. Module according to Claim 1, **characterized in that** the central (7, 31) and side (8, 9, 32, 33, 32', 33') panels are rigid panels.

3. Module according to Claim 1, adapted to a unit comprising a metal shielding partition (6, 6') segregating the two groups of printed circuit cards (4, 5), **characterized in that** said shielding partition (6, 6') is inserted between the two side panels (8, 9, 32, 33) folded and placed flat against one another.

4. Module according to Claim 1, **characterized in that** the two side panels (8, 9, 32, 33, 32', 33') are folded and placed flat against one another parallel to a plane perpendicular to the central panel (7, 31).

5. Module according to Claim 1, **characterized in that** the two side panels (8, 9, 32, 33, 32', 33') are folded and placed flat against one another, parallel and either side of a plane perpendicular to the central panel (7, 31), parallel to the longitudinal edges of the latter and passing through its middle.

6. Module according to Claim 1, **characterized in that** the ends of the through contacts (12) of the offset field of connection points form pins for half-connectors (36 to 39, 52 to 58) mounted back-to-back, on each side of the block consisting of the two side panels (8, 9, 32, 33, 32', 33') folded and placed flat against one another, intended to cooperate by fitting together with half-connectors (15, 16) of complementary shapes mounted on the printed circuit card (4, 5) of each of the two groups of printed circuit cards that directly face the two side panels (8, 9, 32, 33, 32', 33').

7. Module according to Claim 1, **characterized in that** the side panels (8, 9, 32, 33, 32', 33') are provided with an internal field of electrical connection points providing the electrical interconnections between the two groups of printed circuit cards (4, 5) not linked to the contacts (3) of the field of connection points with the environment external to the unit borne by the central panel (7, 31), said internal field of connection points comprising through contacts forming, on the two opposite sides of the block consisting of the two side panels (8, 9, 32, 33, 32', 33') folded and placed flat against one another, pins of half-connectors (41, 42) intended to cooperate by fitting together with half-connectors (43, 44) of complementary shapes mounted on the printed circuit card (4, 5) of each of the two groups of printed circuit cards that directly face the two side panels (32, 33).

8. Module according to Claim 7, **characterized in that** the half-connectors mounted on each side of the block consisting of the two side panels (8, 9, 32, 33, 32', 33') folded and placed flat against one another comprise, indiscriminately, pins consisting of through contacts (12) belonging to the offset field of connection points (36 to 39, 52 to 58) and to the internal field of connection points.

9. Module according to Claim 1, **characterized in that** the part (52 to 55) of the offset field of connection points borne by a side panel (32') is laterally offset relative to the complementary part (56 to 58) of the offset field of connection points borne by the other side panel (33'), each side panel (32' or 33') comprising an opening (50, 50') allowing the part (52 to 55 or 56 to 58) of the offset field of connection points borne by the other side panel (33' or 32') to pass through.

10. Module according to Claim 9, **characterized in that** the ends of the through contacts (12) of the offset field of connection points form half-connectors (52 to 58) fitted on the block consisting of the side panels (32', 33') folded and placed flat against one another have different thicknesses according to the side panel (32' or 33') that supports them so that all show through at the same level on each side of the block even though their fixing levels depend on the side panel (32', 33') that supports them.

11. Module according to Claim 10, **characterized in that** the thickness differences imposed on the half-connectors (52 to 58) fitted on the block consisting of the side panels (32', 33') folded and placed flat against one another, for them to show through at the same level, are obtained by means of shims (59, 60).

12. Module according to Claim 9, **characterized in that** the side panels (32', 33') have identical dissymmetrical contours and are arranged folded and placed flat against one another so as to have non-coinciding contours.

13. Module according to Claim 1, **characterized in that** the ends of the through contacts (12) of the offset field of connection points form half-connectors (36 to 39 and 52 to 58) fitted on the block consisting of the side panels (8, 9, 32, 33, 32', 33') folded and placed flat against one another cooperate with half-connectors of complementary shapes mounted on the printed circuit cards (4, 5) of each of the two groups of printed circuit cards that directly face the two side panels (8, 9, 32, 33, 32', 33'), the pins of which consist of through contacts forming, at their other end, other pins for half-connectors mounted on the opposite side reproducing the half-connectors of the two side panels (8, 9, 32, 33, 32', 33') and making the fields of connection points of the side panels (8, 9, 32, 33, 32', 33') accessible to the next printed circuit card belonging to the same group.

14. Module according to Claim 13, **characterized in that** the printed circuit cards (4, 5) of a group comprise through contacts in alignment with those of the half-connectors (36 to 39, 52 to 58) borne by the side panels (8, 9, 32, 33, 32', 33') forming, on one side of the card (4, 5), pins of half-connectors that can be fitted together with shapes that complement the half-connectors that can be fitted together of the side panels (8, 9, 32, 33, 32', 33') and, on the other side, half-connectors that can be fitted together with shapes the same as those of the side panels making it possible, by being fitted together, to produce with the printed circuit cards of a group, a stack of printed circuit cards having access to all the connection points of the fields of connection points of the side panels.

## Patentansprüche

1. Verbindungsmodul für eine Rückwandverdrahtung einer elektronischen Anlage, die zwei Leiterplattengruppen (4, 5) enthält, die Bauteile für elektronische Anlagen tragen, wobei jede Gruppe aus einer oder mehreren gestapelten Leiterplatten besteht, und mit einer Rückwand, die mit mindestens einem Feld von Kontakten (3) versehen ist, die elektrische Verbindungsstellen darstellen, die vom Gehäuseäußeren aus zugänglich sind, wobei dieses Verbindungsmodul den Versatz, hinsichtlich der zwei Leiterplattengruppen (4, 5), der Verbindungsstellen (3) des Gehäuses gewährleistet, die von außen zugänglich sind, wobei dieses Verbindungsmodul ein Feld mit elektrischen Verbindungsstellen (36 bis 39, 52 bis 58) aufweist, die im Gehäuse den zwei Leiterplattengruppen (4, 5) und den Verbindungsbahnen gegenüber angeordnet sind, die die elektrische Verbindung zwischen diesem versetzten Feld der Verbindungsstellen (36 bis 39, 52 bis 58) und dem Kontaktfeld (3) auf der Rückwand des Gehäuses gewährleisten, und **dadurch gekennzeichnet ist, dass** es einen dreiteiligen planen Träger aufweist, mit:
• einer mittleren Platte (7, 31) mit gedruckter Schaltung, die auf der Rückseite des Kontaktfelds (3) der Verbindungsstellen des Gehäuses mit der externen Umgebung parallel zur Rückwand des Gehäuses befestigt ist und die die elektrischen Verbindungsbahnen auf einem Abschnitt ihres Wegs trägt, der von den Kontakten (3) dieses Felds von Verbindungsstellen mit der externen Umgebung abgeht, wobei diese Verbindungsbahnen sich auf diesem Abschnitt ihres Wegs in mindestens zwei Gruppen teilen, die zu gegenüberliegenden Enden der mittleren Platte führen, Längskanten genannt, und
• zwei seitlichen Platten (8, 9, 32, 33, 32', 33') mit gedruckter Schaltung, die zwischen den zwei Gruppen (4, 5) von Leiterplatten umgebogen sind und gegeneinander anliegen, beiderseits der mittleren Platte (7, 31) an einer Kante mit einer der Längskanten der mittleren Platte (7, 31) befestigt sind, mithilfe eines Verbindungsstücks (10, 11, 34, 35) aus flexibler Leiterplatte, deren Größe ausreicht, um ihre Umbiegung und ihr Anlegen gegeneinander zu erlauben, wobei sie das versetzte Feld von Verbindungsstellen (36 bis 39, 52 bis 58) und der Verbindungsbahnen, die vom Kontaktfeld (3) der Verbindungsstellen des Gehäuses mit der externen Umgebung dorthin führen, gemeinsam benutzen,
wobei das versetzte Feld von Verbindungsstellen (36 bis 39, 52 bis 58) mit durchlaufenden Kontakten (12) versehen sind, die Verbindungsstellen des Abschnitts des versetzten Felds, der von einer seitlichen Platte getragen wird, relativ zu den Verbindungsstellen des ergänzenden Abschnitts des versetzten Felds, das von der anderen seitlichen Platte getragen wird, seitlich versetzt sind, wobei die seitlichen Platten (8, 9, 32, 33), die die Verbindungsbahnen auf dem Teil ihres Weges tragen, der zu ihrem versetzten Feld von Verbindungsstellen führt und mit mindestens einer Öffnung versehen sind, um die durchlaufenden Kontakte (12) der anderen seitlichen Platte durchzulassen, wobei die Verbindungsbahnen zum Abschnitt des versetzten Felds der Verbindungsstellen (36 bis 39, 52 bis 58) einer seitlichen Platte führen, indem sie, um die Kontakte (3) des vom Gehäuseäußeren aus zugänglichen Felds der Verbindungsstellen zu erreichen, das Verbindungsstück (10, 11, 33, 34) durchqueren, das eine der Kanten der betreffenden seitlichen Platte (8, 9, 32, 33, 32', 33') mit einer der Längskanten der mittleren Platte (7, 31) verbindet.

2. Modul nach Anspruch 1, **dadurch gekennzeichnet, dass** die mittleren (7, 31) und seitlichen Platten (8, 9, 32, 33, 32', 33') starre Platten sind.

3. Modul nach Anspruch 1, an ein Gehäuse angepasst, das eine metallische Abschirmwand (6, 6') aufweist, die die zwei Leiterplattengruppen (4, 5) trennt, **dadurch gekennzeichnet, dass** die Abschirmwand (6, 6') zwischen den zwei umgebogenen und gegeneinander anliegenden seitlichen Platten (8, 9, 32, 33) eingefügt ist.

4. Modul nach Anspruch 1, **dadurch gekennzeichnet, dass** die zwei seitlichen Platten (8, 9, 32, 33, 32', 33') parallel zu einer Ebene rechtwinklig zur mittleren Platte (7, 31) umgebogen sind und gegeneinander anliegen.

5. Modul nach Anspruch 1, **dadurch gekennzeichnet, dass** die zwei seitlichen Platten (8, 9, 32, 33, 32', 33') parallel zu und beiderseits einer Ebene, die rechtwinklig zur mittleren Platte (7, 31) ist, parallel zu deren Längskanten ist und durch deren Mitte geht, umgebogen sind und gegeneinander anliegen.

6. Modul nach Anspruch 1, **dadurch gekennzeichnet, dass** die Enden der durchlaufenden Kontakte (12) des versetzten Felds von Verbindungsstellen Stifte für Halbstecker (36 bis 39, 52 bis 58) formen, die Rücken an Rücken auf jeder Seite des Blocks montiert sind, der durch die zwei umgebogenen und gegeneinander anliegenden seitlichen Platten (8, 9, 32, 33, 32', 33') gebildet wird, die dazu bestimmt sind, durch Eingriff mit den Halbsteckern (15, 16) mit komplementärer Form zusammenzuwirken, die auf der Leiterplatte (4, 5) jeder der zwei Leiterplattengruppen montiert sind, die sich auf den zwei seitlichen Platten (8, 9, 32, 33, 32', 33') direkt gegenüberstehen.

7. Modul nach Anspruch 1, **dadurch gekennzeichnet, dass** die seitlichen Platten (8, 9, 32, 33, 32', 33') mit einem internen Feld von elektrischen Verbindungsstellen versehen sind, die die elektrischen Verbindungen zwischen den Leiterplattengruppen (4, 5) herstellen, ohne Verbindung mit den Kontakten (3) des Felds der Verbindungsstellen mit externen Umgebung des Gehäuses, die von der mittleren Platte (7, 31) getragen wird, wobei dieses interne Feld von Verbindungsstellen durchlaufende Kontakte aufweist, die auf den zwei gegenüberliegenden Seiten des Blocks, der aus den zwei umgebogenen und gegeneinander anliegenden seitlichen Platten (8, 9, 32, 33, 32', 33') besteht, Halbsteckerstifte (41, 42) formen, die dazu bestimmt sind, durch Anstecken an Halbstecker (43, 44) mit komplementärer Form zusammenzuwirken, die auf der Leiterplatte (4, 5) jeder der zwei Leiterplattengruppen montiert sind, die sich auf den zwei seitlichen Platten (32, 33) direkt gegenüberstehen.

8. Modul nach Anspruch 7, **dadurch gekennzeichnet, dass** die Halbstecker, die auf jeder Seite des Blocks montiert sind, der aus den zwei umgebogenen und gegeneinander anliegenden seitlichen Platten (8, 9, 32, 33, 32', 33') besteht, unterschiedslos aus durchlaufenden Kontakten (12) bestehende Stifte trägt, die zum versetzten Feld von Verbindungsstellen (36 bis 39, 52 bis 58) und dem internen Feld von Verbindungsstellen gehören.

9. Modul nach Anspruch 1, **dadurch gekennzeichnet, dass** der Teil (52 bis 55) des versetzten Felds von Verbindungsstellen, der von einer seitlichen Platte (32') getragen wird, in Bezug auf den komplementären Teil (56 bis 58) des versetzten Felds von Verbindungsstellen, der von der anderen seitlichen Platte (33') getragen wird, seitlich versetzt ist, wobei jede seitliche Platte (32' oder 33') eine Öffnung (50, 50') aufweist, die den Teil (52 bis 55 oder 56 bis 58) des versetzten Felds von Verbindungsstellen, der von der anderen seitlichen Platte (33' oder 32') getragen wird, durchlässt.

10. Modul nach Anspruch 9, **dadurch gekennzeichnet, dass** die Enden der durchlaufenden Kontakte (12) des versetzten Felds von Verbindungsstellen Halbstecker (52 bis 58) formen, mit denen der aus den umgebogenen und gegeneinander anliegenden seitlichen Platten (32', 33') bestehende Block bestückt ist, je nach der seitlichen Platte (32' oder 33'), von der sie getragen werden, verschiedene Dicken aufweisen, sodass alle auf jeder Seite des Blocks auf gleicher Ebene liegen, auch wenn ihre Befestigungsebenen von der seitlichen Platte (32', 33') abhängig sind, von der sie getragen werden.

11. Modul nach Anspruch 10, **dadurch gekennzeichnet, dass** die Dickenunterschiede, die den Halbsteckern (52 bis 58), mit denen der aus den umgebogenen und gegeneinander anliegenden seitlichen Platten (32', 33') bestehende Block bestückt ist, verliehen werden, damit sie auf gleicher Ebene liegen, mithilfe von Distanzstücken (59, 60) erreicht werden.

12. Modul nach Anspruch 9, **dadurch gekennzeichnet, dass** die seitlichen Platten (32', 33') gleiche unsymmetrische Konturen haben und derart umgebogen und gegeneinander angelegt sind, dass sie nicht deckungsgleiche Konturen aufweisen.

13. Modul nach Anspruch 1, **dadurch gekennzeichnet, dass** die Enden der durchlaufenden Kontakte (12) des versetzten Felds von Verbindungsstellen Halbstecker (36 bis 39 und 52 bis 58) formen, mit denen der aus den umgebogenen und gegeneinander anliegenden seitlichen Platten (8, 9, 32, 33, 32', 33') bestehende Block bestückt ist, mit Halbsteckern komplementärer Form zusammenwirken, die auf den Leiterplatten (4, 5) jeder der zwei Leiterplattengruppen montiert sind, die sich auf den zwei seitlichen Platten (8, 9, 32, 33, 32', 33') direkt gegenüberstehen, deren Stifte aus durchlaufenden Kontakten bestehen, die an ihrem anderen Ende andere Stifte für die auf der Gegenseite montierten Halbstecker formen, die die Halbstecker der zwei seitlichen Platten (8, 9, 32, 33, 32', 33') nachbilden und die Verbindungsstellenfelder der seitlichen Platten (8, 9, 32, 33, 32', 33') der nächsten Leiterplatte, die der gleichen Gruppe angehört, zugänglich machen.

14. Modul nach Anspruch 13, **dadurch gekennzeichnet, dass** die Leiterplatten (4, 5) einer Gruppe durchlaufende Kontakte aufweisen, die mit denen der Halbstecker (36 bis 39, 52 bis 58) ausgerichtet sind, die von den seitlichen Platten (8, 9, 32, 33, 32', 33') getragen werden, wobei sie auf einer Seite der Karte (4, 5) Halbsteckerstifte formen, die an komplementären Formen an den ansteckbaren Halbsteckern der seitlichen Platten (8, 9, 32, 33, 32', 33') ansteckbar sind, und sie auf der anderen Seite ansteckbare Halbstecker gleicher Form wie die der seitlichen Platten formen, die es erlauben, durch Anstecken mit den Leiterplatten einer Gruppe einen Leiterplattenstapel zu formen, der auf sämtliche Verbindungsstellen der Verbindungsstellenfelder der seitlichen Platten Zugriff hat.
